# EUROPEAN PATENT SPECIFICATION

(11) **EP 2 827 690 B1**
(45) Date of publication and mention of the grant of the patent: **26.06.2019**
(21) Application number: 12877754.7
(22) Date of filing: 29.12.2012
(51) Int. Cl.: H05K 7/20, H04Q 1/02

(54) **NETWORK CABINET**
NETZWERKSCHRANK
ARMOIRE DE RÉSEAU

(30) Priority: 31.05.2012 CN 201210176393
(43) Date of publication of application: 21.01.2015
(73) Proprietor: Huawei Technologies Co., Ltd., Longgang District Shenzhen, Guangdong 518129 (CN)
(72) Inventor: ZHANG, Zhao, Shenzhen Guangdong 518129 (CN); ZHANG, Ji, Shenzhen Guangdong 518129 (CN); CUI, Guangzhu, Shenzhen Guangdong 518129 (CN)
(74) Representative: Gill Jennings & Every LLP
(86) International application number: PCT/CN2012/087946
(87) International publication number: WO 2013/177933

(56) References cited:
- CN-A- 1 766 790
- CN-A- 102 196 688
- CN-A- 102 724 848
- US-A- 4 797 783
- US-A1- 2011 222 241
- US-B1- 6 781 831
- US-B1- 7 633 754
- ANTONETTI V W ET AL: "AIR COOLING SCHEME", IBM TECHNICAL DISCLOSURE BULLETIN,, vol. 14, no. 2, 1 July 1971 (1971-07-01), pages 378-379, XP001284818,

## Description

### TECHNICAL FIELD

The present invention relates to the communications field, and in particular, to a network cabinet.

### BACKGROUND

Generally, many mainboards are installed inside a network cabinet. To facilitate heat dissipation of the network cabinet, a fan is installed at a top of the network cabinet, and an air intake vent is disposed at a bottom of the network cabinet. However, this air exhaust manner brings heat from mainboards at the bottom of the network cabinet to mainboards at the top of the network cabinet. As a result, the mainboards at the top of the network cabinet are always in a high temperature environment, which causes rapid aging of the mainboards at the top of the network cabinet.

US 7,633,754 discloses an air cooling system for an electronics rack.

US 2011/0222241 discloses that a high density switching platform arranges multiple circuit cards interconnected by a single backplane.

US 6,781,831 discloses that an improved circuit board assembly includes a cover or other member disposed adjacent to the substrate and, for example, spaced therefrom so as to define a plenum.

### SUMMARY

The technical problem to be solved by embodiments of the present invention is the following problem: in the prior art, mainboards at a top are exposed to heat from mainboards at a bottom because air is expelled in a single direction from the top of a cabinet.

Various aspects and embodiments of the present invention are set out in the appended claims.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a schematic diagram of a first embodiment of a network cabinet according to the present invention;
FIG. 2 is a schematic diagram of an internal case of the network cabinet in FIG. 1;
FIG. 3 is a schematic diagram illustrating a heat dissipation state of the network cabinet in FIG. 1;
FIG. 4 is a schematic diagram of a third mainboard of the network cabinet in FIG. 1; and
FIG. 5 is a schematic diagram of a second embodiment of a network cabinet according to the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by persons of ordinary skill in the art based on the embodiments of the present invention without creative efforts shall fall within the protection scope of the present invention.

In embodiments of the present invention, a first air exhaust apparatus is disposed at a top of the network cabinet, and meanwhile a second air exhaust apparatus is disposed at a bottom of the network cabinet, so that the network cabinet can perform heat dissipation for mainboards at the top and at the bottom simultaneously to obtain an even heat dissipation environment, thereby preventing the mainboards at the top of the network cabinet from aging early.

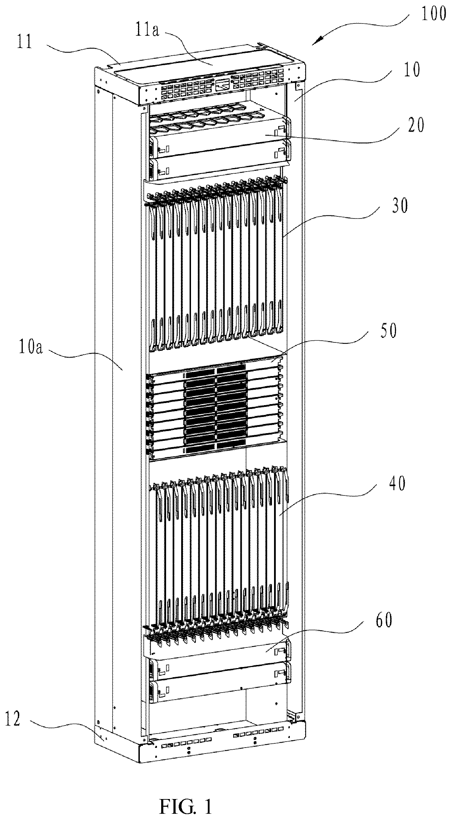

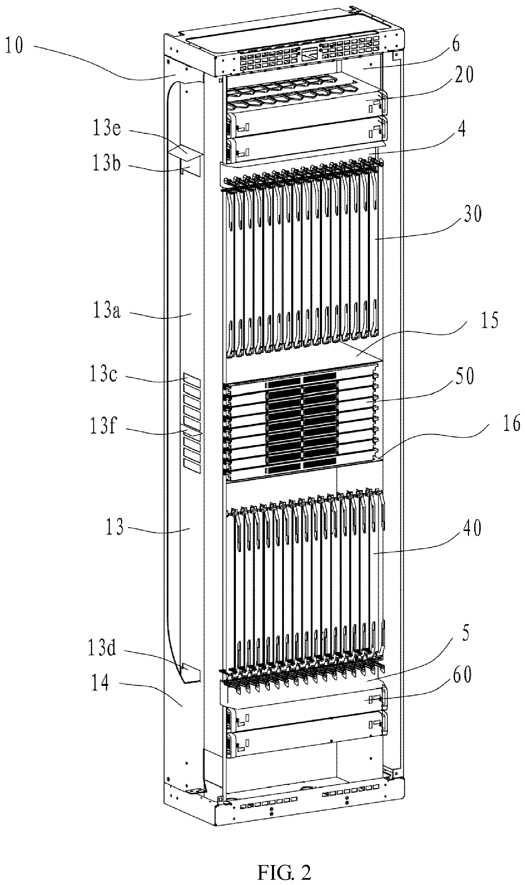

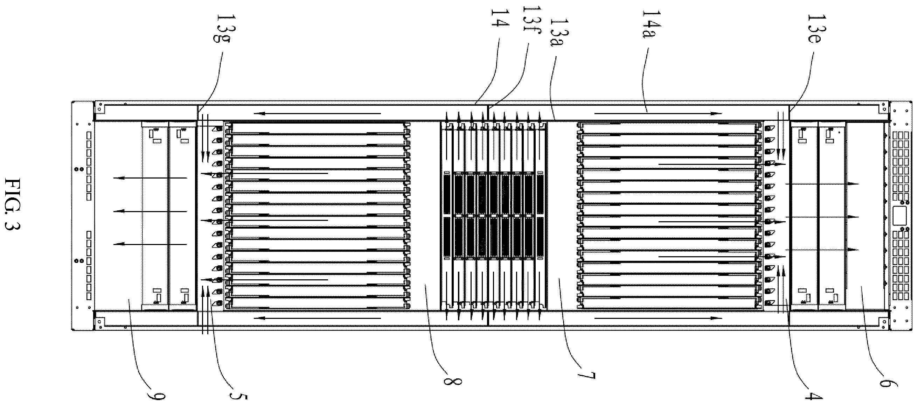

With reference to FIG. 1 to FIG. 3, a first embodiment of the present invention provides a network cabinet 100. The network cabinet 100 includes an enclosure 10, a first air exhaust apparatus 20, 16 first mainboards 30, 16 second mainboards 40, 9 third mainboards 50, and a second air exhaust apparatus 60. The first air exhaust apparatus 20, the first mainboards 30, the third mainboards 50, the second mainboards 40, and the second air exhaust apparatus 60 are fixed inside the enclosure 10 in sequence from a top 11 of the enclosure 10 to a bottom 12 of the enclosure 10.

In this implementation manner, the top 11 of the enclosure 10 and the bottom 12 of the enclosure 12 are disposed oppositely; and a middle 10a of the enclosure 10 is disposed between the top 11 and the bottom 12. The enclosure 10 includes an internal case 13, an external case 14, a first partition plate 15, and a second partition plate 16. The internal case 13 is contained in the external case 14, and the internal case 13 includes two side walls 13a that are disposed oppositely, where the side walls 13a and interior walls of the enclosure 14 form an air duct 14a. The first air exhaust apparatus 20, the first mainboards 30, the second mainboards 40, the third mainboards 50, and the second air exhaust apparatus 60 are fixed between the two side walls 13a. A first air vent 13b, a second air vent 13c, and a third air vent 13d are disposed on the side wall 13a. The two first air vents 13b, the two second air vents 13c, and the two third air vents 13d of the two side walls 13a are oppositely disposed respectively.

The first air vent 13b faces a gap 4 between the first air exhaust apparatus 20 and the first mainboards 30. The first air vent 13b is a rectangular through hole and is configured to lead warm air inside the air duct 14a into a position below the first air exhaust apparatus 20, and the first air exhaust apparatus 20 expels the warm air. To lead the warm air, an air baffle 13e is further fixed at an upper edge of the first air vent 13b. The air baffle 13e is configured to prevent the warm air inside the air duct 14a from continuing to go upwards but direct the warm air into the first air vent 13b.

The second air vent 13c faces the third mainboards 50, and the second air vent 13c is configured to lead warm air expelled by the third mainboards 50 into the air duct 14a; second air vents 13c whose quantity is the same as the quantity of the third mainboards 50 are disposed on the side wall 13a, and each second air vent 13c faces a side of one of the third mainboards 50. To allocate air exhaust paths to the multiple third mainboards 50, an air blocking panel 13f is disposed between the nine second air vents 13c, where the air blocking panel 13f partitions the second air vents 13c into five air vents on the upper side and four air vents on the lower side. The air blocking panel 13f is configured to keep warm air expelled by the five second air vents 13c on the upper side in the upper part of the air duct 14a and keep warm air expelled by the four second air vents 13c on the lower side in the lower part of the air duct 14a, so that the warm air expelled by the multiple third mainboards 50 are distributed properly.

The third air vent 13d faces a gap 5 between the second mainboards 40 and the second air exhaust apparatus 60. The third air vent 13d is a rectangular through hole and is configured to lead warm air inside the air duct 14a into a position above the second air exhaust apparatus 60, and the second air exhaust apparatus 60 expels the warm air. To lead the warm air, an air baffle 13g that is the same as the air baffle 13e is further fixed at a lower edge of the third air vent 13d, and is configured to prevent the warm air inside the air duct 14a from continuing to move downwards but direct the warm air into the third air vent 13d.

The first partition plate 15 is fixed between the first mainboards 30 and the third mainboards 50 to separate the first mainboards 30 from the third mainboards 50 and prevent warm air expelled by the third mainboards 50 from entering the first air exhaust apparatus 20 through the first mainboards 30. The second partition plate 16 is fixed between the second mainboards 40 and the third mainboards 50 to separate the second mainboards 40 from the third mainboards 50 and prevent the warm air expelled by the third mainboards 50 from entering the second air exhaust apparatus 60 through the second mainboards 40. In this implementation manner, a housing space is formed between the first partition plate 15 and the second partition plate 16; and the third mainboards 50 are arranged between the first partition plate 15 and the second partition plate 16.

The first air exhaust apparatus 20 is disposed at the top 11 of the enclosure 10, and is configured to draw air from the middle 10a, draw the air from the middle 10a to the top 11, and expel the air from the top 11. In this implementation manner, the first air exhaust apparatus 20 is a fan. The first air exhaust apparatus 20 is disposed in an upper half part of the internal case 13; and a gap 6 is reserved between the first air exhaust apparatus 20 and a top wall of the internal case 13 and is used as an air exhaust vent in the upper part. In addition, an air exhaust vent 11a is disposed at the top wall of the internal case 13. Air expelled by the first air exhaust apparatus 20 is expelled through the gap 6 and the air exhaust vent 11a. An air intake vent of the first air exhaust apparatus 20 faces the first mainboards 30, and an air exhaust vent of the first air exhaust apparatus faces the top wall of the internal case 13. Two sides of the first air exhaust apparatus 20 are fixed on the two side walls 13a respectively.

The first mainboards 30 are close to the top 11 of the enclosure 11, are vertically arranged inside the enclosure 10 and are mutually parallel. Warm air entering from the first air vent 13b is led into the first air exhaust apparatus 20 through the gap 4 between the first mainboards 30 and the first air exhaust apparatus 20. In this implementation manner, the first mainboards 30 are fixed between the two side walls 13a by brackets (not marked in the figure). The first mainboards 30 draw air from a side facing an external part of the network cabinet 100, and expel air from an upper side of the first mainboards 30.

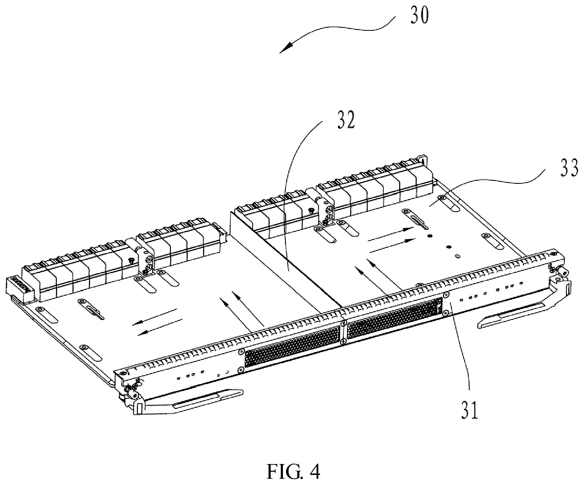

The nine third mainboards 50 are mutually parallel, are horizontally arranged inside the enclosure 10, and are located in the middle 10a of the enclosure 10. The third mainboards 50 draw air from a side 31 facing an external part of the network cabinet 100 (as shown in FIG. 4). A gap 7 is reserved between the third mainboards 50 and the first mainboards 30, and is used as an air intake vent to lead cold air into the first mainboards 30. Each third mainboard 50 further includes a flow dividing plate 32, where the flow dividing plate 32 separates the third mainboard 30 into two parts 33, where the separated two parts 33 of the third mainboard 30 expel air to the two side walls 13a respectively, that is, expel air from the left side and from the right side.

The second mainboards 40 are close to the bottom 12 of the enclosure 10, are vertically arranged inside the enclosure 10 and are mutually parallel. In this implementation manner, the second mainboards 40 are fixed between the two side walls 13a by using brackets (not marked in the figure). The second mainboards 40 are installed in a manner opposite to the up-down directions of the first mainboards 30. A gap 8 is reserved between the second mainboards 40 and the third mainboards 50, and is used as an air intake vent to lead cold air into the second mainboards 40. The second mainboards 40 draw air from a side facing an external part of the network cabinet 100, and expel air from a lower side of the second mainboards 40.

The second air exhaust apparatus 60 is disposed at the bottom 12 of the enclosure 10, and is configured to draw air from the middle 10a, draw the air from the middle 10a to the top 12, and expel the air from the top 12. In this implementation manner, the second air exhaust apparatus 60 is a fan. The second air exhaust apparatus 60 is disposed in a lower half part of the internal case 13; and a gap 9 is reserved between the second air exhaust apparatus 60 and a bottom wall of the internal case 13 and is used as an air exhaust vent in the lower part. An air intake vent of the second air exhaust apparatus 60 faces the second mainboards 40, and an air exhaust vent of the second air exhaust apparatus 60 faces the bottom wall of the internal case 13. Two sides of the second air exhaust apparatus 60 are fixed on the two side walls 13a respectively.

In the network cabinet provided in this implementation manner, a first air exhaust apparatus and a second air exhaust apparatus are disposed on an upper side and on a lower side, which improves an air exhaust ability and prevents impact of warm air dissipated by electronic devices on the lower side on electronic devices on the upper side. According to a test, by using the second air exhaust apparatus, the heat dissipation ability of the network cabinet can be improved by 40%.

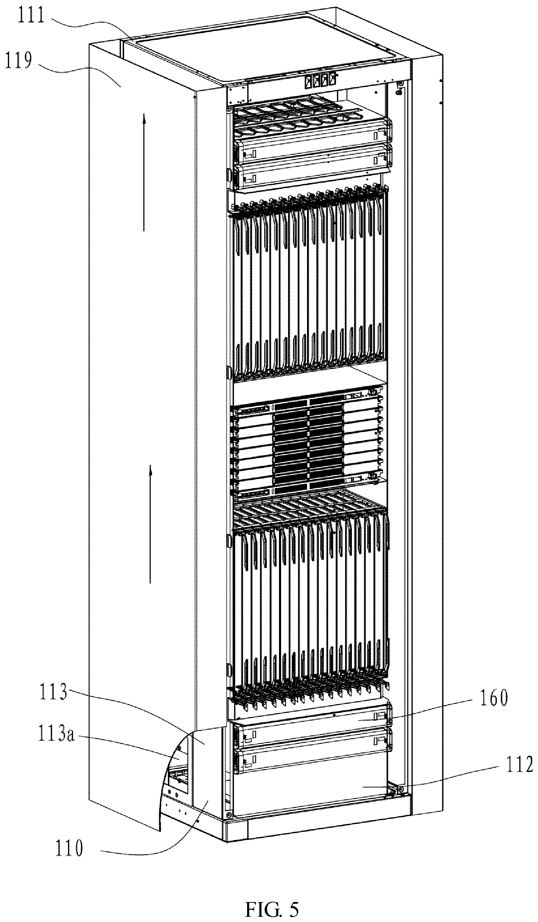

As shown in FIG. 5, a second embodiment of the present invention provides a network cabinet 200. The network cabinet 200 is basically the same as the network cabinet 100 provided in the first implementation manner, with a difference in that the front of a bottom 112 of the network cabinet is closed and a fourth air vent 113a is disposed on a side wall 113, where the fourth air vent 113a is located at the bottom of a second air exhaust apparatus 160 and is configured to lead out warm air expelled by the second air exhaust apparatus 160. The fourth air vent 113a goes through the enclosure 110, two air circulation units 119 are fixed on both sides of the enclosure 110, and the air circulation units 119 guide warm air expelled by the fourth air vent 113a to a top 111 of the enclosure 110 to expel the air. Certainly, in other implementation manners, the fourth air vent 113a may also be disposed on a rear side of the enclosure 110.

## Claims

1. A network cabinet (100), comprising an enclosure (10), a first air exhaust apparatus (20), a second air exhaust apparatus (60), multiple first mainboards (30), multiple second mainboards (40) and multiple third mainboards (50), wherein the enclosure (10) comprises a top (11), a middle (10a), and a bottom (12) in sequence, wherein the top (11) and the bottom (12) are disposed oppositely, the first air exhaust apparatus (20) is disposed at the top (11) and is configured to draw air from the middle (10a), draw the air from the middle (10a) to the top (11), and expel the air from the top (11), and the second air exhaust apparatus (60) is disposed at the bottom (12) and is configured to draw air from the middle (10a), draw the air from the middle (10a) to the bottom (12), and expel the air from the bottom (12), wherein the multiple first mainboards (30) are close to the top (11) of the enclosure (10), are vertically arranged inside the enclosure (10) and are mutually parallel, the first air exhaust apparatus (20) is located between the multiple first mainboards (30) and the top (11) of the enclosure (10), the multiple second mainboards (40) are close to the bottom (12) of the enclosure (10), are vertically arranged inside the enclosure (10) and are mutually parallel, and the second air exhaust device is located between the multiple second mainboards (40) and the bottom (12) of the enclosure (10), and wherein the multiple third mainboards (50) are contained inside the enclosure (10) and are located between the multiple first mainboards (30) and the multiple second mainboards (40) and wherein the multiple third mainboards (50) are mutually parallel and are horizontally arranged inside the enclosure (10), and **characterised in that** the network cabinet (100) further comprises an internal case (13), an external case (14), a first partition plate (15), and a second partition plate (16), wherein the internal case (13) is contained in the external case (14) and comprises two side walls (13a) disposed oppositely, wherein the side walls (13a) and interior walls of the external case (14) form an air duct (14a); the first air exhaust apparatus (20), the second air exhaust apparatus (60), the multiple first mainboards (30), the multiple second mainboards (40), and the multiple third mainboards (50) are fixed between the two side walls (13a); a first air vent (13b), a second air vent (13c), and a third air vent (13d) are disposed on each side wall, wherein the first air vent (13b) faces a gap (4) between the first air exhaust apparatus (20) and the multiple first mainboards (30), the second air vent (13c) faces the multiple third mainboards (50), and the third air vent (13d) faces a gap (5) between the multiple second mainboards (40) and the second air exhaust apparatus (60); and the first partition plate (15) is disposed between the multiple first mainboards (30) and the multiple third mainboards (50) to separate the multiple first mainboards (30) from the multiple third mainboards (50), and the second partition plate (16) is disposed between the multiple second mainboards (40) and the multiple third mainboards (50) to separate the multiple second mainboards (40) from the multiple third mainboards (50).

2. The network cabinet (100) according to claim 1, wherein the third mainboards (50) further comprises a flow dividing plate (32), wherein the flow dividing plate (32) separates the third mainboards (50) into two parts, wherein the separated two parts of the third mainboards (50) expel air to the two side walls (13a) respectively.

3. The network cabinet (100) according to claim 1, wherein a fourth air vent (113a) is further disposed on each side wall (13a), wherein the fourth air vent (113a) is located at the bottom of the second air exhaust apparatus (60).

4. The network cabinet (100) according to any one of claims 1 to 3, wherein the first air exhaust apparatus (20) and the second air exhaust apparatus (60) are all fans.

## Patentansprüche

1. Netzwerkschrank (100), ein Gehäuse (10), eine erste Luftauslassvorrichtung (20), eine zweite Luftauslassvorrichtung (60), mehrere erste Hauptplatinen (30), mehrere zweite Hauptplatinen (40) und mehrere dritte Hauptplatinen (50) umfassend, wobei das Gehäuse (10) eine Oberseite (11), eine Mitte (10a) und einen Boden (12) in Sequenz umfasst, wobei die Oberseite (11) und der Boden (12) gegenüberliegend angeordnet sind, die erste Luftauslassvorrichtung (20) an der Oberseite (11) angeordnet und konfiguriert ist, Luft aus der Mitte (10a) zu saugen, die Luft aus der Mitte (10a) zu der Oberseite (11) zu saugen und die Luft von der Oberseite (11) auszustoßen, und die zweite Luftauslassvorrichtung (60) an dem Boden (12) angeordnet und konfiguriert ist, Luft von der Mitte (10a) zu saugen, Luft von der Mitte (10a) zu dem Boden (12) zu saugen und die Luft von dem Boden (12) auszustoßen, wobei die mehreren ersten Hauptplatinen (30) nahe an der Oberseite (11) des Gehäuses (10) sind, vertikal innerhalb des Gehäuses (10) angeordnet und gemeinsam parallel zueinander sind, die erste Luftauslassvorrichtung (20) zwischen den mehreren ersten Hauptplatinen (30) und der Oberseite (11) des Gehäuses (10) positioniert ist, die mehreren zweiten Hauptplatinen (40) nahe an dem Boden (12) des Gehäuses (10) positioniert sind, vertikal innerhalb des Gehäuses (10) angeordnet und gegenseitig parallel sind, und die zweite Luftauslassvorrichtung zwischen den mehreren zweiten Hauptplatinen (40) und dem Boden (12) des Gehäuses (10) angeordnet ist, und wobei die mehreren dritten Hauptplatinen (50) innerhalb des Gehäuses (10) enthalten sind und zwischen den mehreren ersten Hauptplatinen (30) und den mehreren zweiten Hauptplatinen (40) positioniert sind, und wobei die mehreren dritten Hauptplatinen (50) gegenseitig parallel sind und horizontal innerhalb des Gehäuses (10) angeordnet sind, und **dadurch gekennzeichnet, dass** der Netzwerkschrank (100) ferner einen internen Kasten (13), einen externen Kasten (14), eine erste Partitionsplatte (15) und eine zweite **P**artitionsplatte (16) umfasst, wobei der interne Kasten (13) in dem externen Kasten (14) enthalten ist und zwei Seitenwände (13a) umfasst, die gegenüberliegend angeordnet sind, wobei die Seitenwände (13a) und Innenwände des externen Kastens (14) einen Luftkanal (14a) bilden; die erste Luftauslassvorrichtung (20), die zweite Luftauslassvorrichtung (60), die mehreren ersten Hauptplatinen (30), die mehreren zweiten Hauptplatinen (40) und die mehreren dritten Hauptplatinen (50) zwischen den beiden Seitenwänden (13a) fixiert sind; eine erste Luftöffnung (13b), eine zweite Luftöffnung (13c) und eine dritte Luftöffnung (13d) an jeder Seitenwand angeordnet sind, wobei die erste Luftöffnung (13b) einem Spalt (4) zwischen der ersten Luftauslassvorrichtung (20) und den mehreren ersten Hauptplatinen (30) zugewandt ist, die zweite Luftöffnung (13c) den mehreren dritten Hauptplatinen (50) zugewandt ist und die dritte Luftöffnung (13d) einem Spalt (5) zwischen den mehreren zweiten Hauptplatinen (40) und der zweiten Luftauslassvorrichtung (60) zugewandt ist; und die erste Partitionsplatte (15) zwischen den mehreren ersten Hauptplatinen (30) und den mehreren dritten Hauptplatinen (50) angeordnet ist, um die mehreren ersten Hauptplatinen (30) von den mehreren dritten Hauptplatinen (50) zu trennen, und die zweite Partitionsplatte (16) zwischen den mehreren zweiten Hauptplatinen (40) und den mehreren dritten Hauptplatinen (50) angeordnet ist, um die mehreren zweiten Hauptplatinen (40) von den mehreren dritten Hauptplatinen (50) zu trennen.

2. Netzwerkschrank (100) nach Anspruch 1, wobei die dritten Hauptplatinen (50) ferner eine Strömungsteilerplatte (32) umfassen, wobei die Strömungsteilerplatte (32) die dritten Hauptplatinen (50) in zwei Teile teilt, wobei die aufgeteilten zwei Teile der dritten Hauptplatinen (50) Luft jeweils zu den beiden Seitenwänden (13a) abführen.

3. Netzwerkschrank (100) nach Anspruch 1, wobei ferner eine vierte Luftöffnung (113a) an jeder Seitenwand (13a) angeordnet ist, wobei die vierte Luftöffnung (113a) an dem Boden der zweiten Luftauslassvorrichtung (60) positioniert ist.

4. Netzwerkschrank (100) nach einem der Ansprüche 1 bis 3, wobei die erste Luftauslassvorrichtung (20) und die zweite Luftauslassvorrichtung (60) Lüfter sind.

## Revendications

1. Armoire de réseau (100), comprenant une enceinte (10), un premier appareil d'évacuation d'air (20), un deuxième appareil d'évacuation d'air (60), de multiples premières cartes mères (30), de multiples deuxièmes cartes mères (40) et de multiples troisièmes cartes mères (50), l'enceinte (10) comprenant un dessus (11), un milieu (10a) et un fond (12) en séquence, le dessus (11) et le fond (12) étant disposés en regard l'un de l'autre, le premier appareil d'évacuation d'air (20) étant disposé au niveau du dessus (11) et étant configuré pour aspirer l'air du milieu (10a), aspirer l'air du milieu (10a) vers le dessus (11), et expulser l'air par le dessus (11), et le deuxième appareil d'évacuation d'air (60) étant disposé au niveau du fond (12) et étant configuré pour aspirer l'air du milieu (10a), aspirer l'air du milieu (10a) vers le fond (12), et expulser l'air par le fond (12), les multiples premières cartes mères (30) étant proches du dessus (11) de l'enceinte (10), étant disposées verticalement à l'intérieur de l'enceinte (10) et étant parallèles entre elles, le premier appareil d'évacuation d'air (20) étant situé entre les multiples premières cartes mères (30) et le dessus (11) de l'enceinte (10), les multiples deuxièmes cartes mères (40) étant situées à proximité du fond (12) de l'enceinte (10), étant disposées verticalement à l'intérieur de l'enceinte (10) et étant parallèles entre elles, et le deuxième appareil d'évacuation d'air étant situé entre les multiples deuxièmes cartes mères (40) et le fond (12) de l'enceinte (10), et les multiples troisièmes cartes mères (50) étant contenues à l'intérieur de l'enceinte (10) et étant situées entre les multiples premières cartes mères (30) et les deuxièmes cartes mères (40), et les multiples troisièmes cartes mères (50) étant parallèles entre elles et étant disposées horizontalement à l'intérieur de l'enceinte (10), et **caractérisée en ce que** l'armoire de réseau (100) comprend en outre un boîtier interne (13), un boîtier externe (14), une première plaque de séparation (15) et une deuxième plaque de séparation (16), le boîtier interne (13) étant contenu dans le boîtier externe (14) et comprenant deux parois latérales (13a) disposées en regard l'une de l'autre, les parois latérales (13a) et les parois intérieures du boîtier externe (14) formant une conduite d'air (14a) ; le premier appareil d'évacuation d'air (20), le deuxième appareil d'évacuation d'air (60), les multiples premières cartes mères (30), les multiples deuxièmes cartes mères (40) et les multiples troisièmes cartes mères (50) étant fixées entre les deux parois latérales (13a) ; un premier évent d'aération (13b), un deuxième évent d'aération (13c), et un troisième évent d'aération (13d) étant disposés sur chaque paroi latérale, le premier évent d'aération (13b) faisant face à un interstice (4) entre le premier appareil d'évacuation d'air (20) et les multiples premières cartes mères (30), le deuxième évent d'aération (13c) faisant face aux multiples troisièmes cartes mères (50), et le troisième évent d'aération (13d) faisant face à un interstice (5) entre les multiples deuxièmes cartes mères (40) et le deuxième appareil d'évacuation d'air (60) ; et la première plaque de séparation (15) étant disposée entre les multiples premières cartes mères (30) et les multiples troisièmes cartes mères (50) pour séparer les multiples premières cartes mères (30) des multiples troisièmes cartes mères (50), et la deuxième plaque de séparation (16) étant disposée entre les multiples deuxièmes cartes mères (40) et les multiples troisièmes cartes mères (50) pour séparer les multiples deuxièmes cartes mères (40) des multiples troisièmes cartes mères (50).

2. Armoire de réseau (100) selon la revendication 1, dans lequel les troisièmes cartes mères (50) comprennent en outre une plaque de division de flux (32), la plaque de division de flux (32) séparant les troisièmes cartes mères (50) en deux parties, les deuxième parties séparées des troisièmes cartes mères (50) expulsant l'air vers les deux parois latérales (13a) respectives.

3. Armoire de réseau (100) selon la revendication 1, dans lequel un quatrième évent d'aération (113a) est en outre disposé sur chaque paroi latérale (13a), le quatrième évent d'aération (113a) étant situé au niveau du fond du deuxième appareil d'évacuation d'air (60).

4. Armoire de réseau (100) selon l'une quelconque des revendications 1 à 3, dans lequel le premier appareil d'évacuation d'air (20) et le deuxième appareil d'évacuation d'air (60) sont tous des ventilateurs.
